# EUROPEAN PATENT SPECIFICATION

(11) **EP 3 696 555 B1**
(45) Date of publication and mention of the grant of the patent: **11.05.2022**
(21) Application number: 20157335.9
(22) Date of filing: 14.02.2020
(51) Int. Cl.: G01R 1/067

(54) **PROBE DEVICE OF FLOATING STRUCTURE**
SONDENVORRICHTUNG EINER SCHWIMMENDEN STRUKTUR
DISPOSITIF DE SONDE D'UNE STRUCTURE FLOTTANTE

(30) Priority: 15.02.2019 KR 20190017522
(43) Date of publication of application: 19.08.2020
(73) Proprietor: Phoenixon Controls Inc., Gyeonggi-do 18487 (KR)
(72) Inventor: NAH, Ki Sool, 18446 GYEONGGI-DO (KR)
(74) Representative: Ter Meer Steinmeister & Partner

(56) References cited:
- US-A1- 2002 197 891
- US-A1- 2006 103 405
- US-A1- 2011 117 796
- US-A1- 2018 335 447
- US-B1- 7 507 110
- US-B1- 8 269 516

## Description

### BACKGROUND

### Technical Field

The present invention relates to a probe device of a floating structure, and more particularly, to a probe device of a floating structure capable of compensating for an inclination at a predetermined angle in response to an external force applied thereto.

### Background Art

A semiconductor chip is manufactured through a process of forming a circuit pattern on a wafer and a process of assembling a module on the water with the circuit pattern by assembling each cell of each battery pack as a module, and a plurality of probe devices has been used between the manufacturing process and the assembling process to examine electric characteristics of each cell.

However, most conventional probe devices have a problem in that an overcurrent phenomenon occurs in a point contact portion when a current flows as the contact portion is point-contacted. This overcurrent phenomenon caused sparks to cause product defects.

As a solution for this problem, there is a surface-contact probe device in which the entire surface rather than the point contact is uniformly contacted. However, in the case of the surface-contact probe device, there is a problem that a terminal may be assembled to be inclined when assembling the terminal.

In addition, the surface-contact probe device has a problem in that when the external force is applied to a needle to be coupled to a pack terminal without a compensation for the bending degree depending on the external force, the needle may be bent according to a size and a direction of the external force and the bending of the needle has a bad effect on the terminal.

US 2002/197891 A1 relates to an IC socket for an IC package as an electrical part that has a socket body to which a number of contact pins are arranged so as to establish an electrical connection between a printed circuit board and a terminal of the IC package. The contact pin comprises a first contact piece disposed on an electrical part side so as to contact the terminal of the electrical part and a second contact piece disposed on a printed circuit board side so as to contact the printed circuit board. When the first contact piece contacts the terminal and is pressed, the second contact piece is inclined and a contact end portion of the second contact piece is moved so as to slide with respect to the electrical part.

US 8 269 516 B1 relates to a contactor interconnect in an integrated circuit device test fixture that comprises a plurality of contactor pins enabled to provide electrical contact with the contact points of an integrated circuit device, the contactor pins being mounted in the test fixture; and an electrical circuit coupled to two or more of the contactor pins of the test fixture, wherein the electrical circuit is isolated from other contactor pins of the plurality of contactor pins and wherein the electrical circuit is coupled to the two or more contactor pins by an electronically direct pathway.

US 2018/335447 A1 relates to a contact probe that includes a tube which is electrically conductive, a plunger which is electrically conductive and disposed in the tube at one end of the tube, and a spring which is disposed in the tube and urges the plunger in a projection direction. The tube includes a slant portion on an inner circumferential surface of the tube. The slant portion is inclined with respect to an axial direction of the tube. A base portion comes into contact with the slant portion and an inclination of the plunger varies, when the plunger retracts.

US 2006/103405 A1 relates to a method and apparatus for a wiping fixture probe for cleaning oxides, residues or other contaminants from the surface of a solder bead probe and probing a solder bead probe on a printed circuit board during in-circuit testing.

US 2011/117796 A1 relates to a probe pin that includes a barrel having an internal space extending from one end to the other end, a plunger provided at the one end of the barrel, a plunger provided at the other end of the barrel, and a coil spring received in the barrel for supporting the plungers elastically. The coil spring includes a central portion having substantially same diameter, a first taper portion adjacent to one end of the central portion and having diameters decreased gradually, and a second taper portion adjacent to the other end of the central portion and having diameters decreased gradually.

US 7 507 110 B1 relates to a probe connector that includes a barrel, a plunger and an elastic element. The barrel disposes a base at one end thereof. The plunger has a basic portion received in the barrel and a contact portion extending out of the barrel from the other end of the barrel opposite to the base. The elastic element is arranged inside the barrel. Two ends of the elastic element are respectively mounted to the basic portion of the plunger and the base and are mounted in a manner such that the two ends of the elastic element are offset and the elastic element is distorted. As the elastic element is distorted inside the barrel, the supporting force provided by the elastic element is not in line with the longitudinal axis of the plunger. The component force of the supporting force provided by the elastic element along the transverse direction is increased, so the plunger is biased to contact the barrel stably.

### SUMMARY OF THE DISCLOSURE

The present invention has been derived to solve the above-described problems of the prior art, and an object of the present invention is to provide a probe device of a floating structure capable of compensating for an external force applied to a needle.

Another object of the present invention is to provide a probe device of a floating structure capable of providing a restoring force against an inclination when the external force is removed.

The objects of the present invention are not limited to the above-mentioned objects, and other objects not mentioned will be clearly understood by those skilled in the art from the following description.

The objects of the present invention are solved by the features of the independent claims. Preferred embodiments are given in the dependent claims.

An aspect of the present invention provides a probe device of a floating structure as defined by the claim 1.

The probe unit may include an elastic portion which is provided to transmit the external force applied to the needle to the guide portion or so that the guide portion contacts the inner space when the external force applied to the needle is removed.

The guide portion may be formed such that a part thereof becomes larger in width in a longitudinal direction.

Another aspect of the present invention provides a probe device of a floating structure 2. as defined by the claim 5.

The guide portion includes a guide member having one end formed in a spherical shape and an accommodation space formed to accommodate the guide member.

The elastic unit may be provided in plural and an axis of the probe unit may be inclined with respect to an axis of the guide portion according to the external force.

The plate unit may include a plate member installed to be inserted with the guide portion and a spring member providing a restoring force to the plate member when the external force is removed.

The probe device of the floating structure of the present invention for solving the above problems has the following effects.

First, it is possible to compensate for the inclination of the probe unit based on the plate unit in response to the external force.

Second, it is possible to restore the probe device to a state before the external force is applied by providing a restoring force when the external force is removed.

The effects of the present invention are not limited to the aforementioned effect, and other effects, which are not mentioned above, will be apparent to a person having ordinary skill in the art from the description of the claims.

### BRIEF DESCRIPTION OF THE DRAWINGS

The above and other features of the present invention will now be described in detail with reference to certain embodiments thereof illustrated the accompanying drawings which are given hereinbelow by way of illustration only, and thus are not limitative of the present invention, and wherein:
FIGS. 1 to 4 illustrate a first embodiment of a probe device of a floating structure of the present invention; and
FIGS. 5 to 7 illustrate a second embodiment of a probe device of a floating structure of the present invention.

### DETAILED DESCRIPTION

Hereinafter, preferred embodiments of the present invention, in which a purpose of the present invention can be realized in detail, will be described with reference to the accompanying drawings. In describing the embodiment, the same name and the same reference numeral are used with respect to the same component and the resulting additional description will be omitted.

In addition, in the following description of the embodiments of the present invention, components having the same function just use the same names and the same reference numerals, and are not substantially identical to the prior art.

Terms used in the embodiments of the present invention are used only to describe specific exemplary embodiments, and are not intended to limit the present invention. A singular form may include a plural form if there is no clearly opposite meaning in the context.

In the embodiments of the present invention, it should be understood that the term "include" or "have" indicates that a feature, a number, a step, an operation, a component, a part, or the combination thereof described in the specification is present, but does not exclude a possibility of presence or addition of one or more other features, numbers, steps, operations, components, parts, or combinations thereof, in advance.

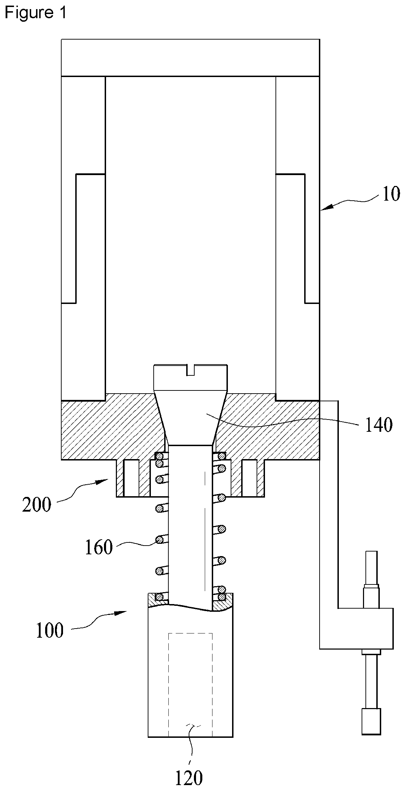

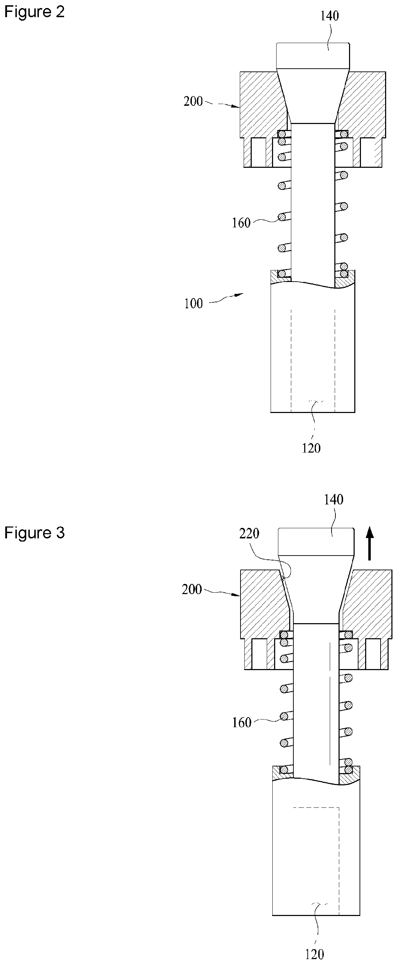

A first embodiment of a probe device of a floating structure of the present invention will be described with reference to FIGS. 1 to 4. FIGS. 1 to 4 illustrate a first embodiment of a probe device of a floating structure of the present invention.

According to the first embodiment, the probe device of the floating structure of the present invention includes a probe unit 100 and a plate unit 200.

The probe unit 100 has a groove 120 formed at one end thereof into which a needle for transmitting an electrical signal is inserted, and a guide portion 140 formed at the other end thereof.

The needle may serve as a tip input to the terminal, and an area to be contacted or a contacting method may be various. The groove 120 may be formed in response to the area or method in which the needle is contacted, and the needle is coupled to the groove 120 to transmit an electrical signal.

The guide portion 140 may compensate for an inclined strain according to the external force applied to the probe unit 100.

The plate unit 200 may include an inner space 220 which is inserted with the guide portion 140 and formed to support a part of the guide portion 140.

That is, at least a part of the guide portion 140 may be located in the inner space 220 of the plate unit 200. The plate unit 200 may be a component coupled to a part of a pack terminal block 10 or the pack terminal block 10 as illustrated in FIG. 1 and may be formed in various ways.

With respect to a relationship between the guide portion 140 and the plate unit 200, the guide portion 140 may be spaced apart from the inner space 220 at a predetermined interval by the external force applied to the needle.

Specifically, when the needle is not coupled to the groove 120, that is, the needle is removed from the groove 120, the guide portion 140 may be provided so that a part thereof contacts a part of the inner space 220. Accordingly, the inner space 220 is preferably formed to correspond to the shape of the guide portion 140. However, the shape of the inner space 220 is not limited as long as the function above may be performed.

In addition, the guide portion 140 may be spaced apart from the inner space 220 at a predetermined interval by the external force applied while the needle is coupled to the groove 120.

At this time, the probe unit 100 may further include an elastic portion 160.

The elastic portion 160 may be provided to transmit the external force applied to the needle to the guide portion 140 or so that the guide portion 140 contacts the inner space 220 when the external force applied to the needle is removed.

Specifically, when the needle is coupled to the groove 120 by the external force, the elastic portion 160 may transmit the external force to the guide portion 140 so that the guide portion 140 is spaced apart from the inner space 220 at a predetermined interval.

In addition, when the needle is removed from the groove 120, the elastic portion 160 may provide a restoring force to the guide portion 140 so that a part of the guide portion 140 is supported to contact a part of the inner space 220.

As the guide portion 140 is spaced apart from the inner space 220 by the elastic portion 160, the present invention may compensate for the inclination of an axis of the guide portion 140 generated while the needle is coupled to the groove 120.

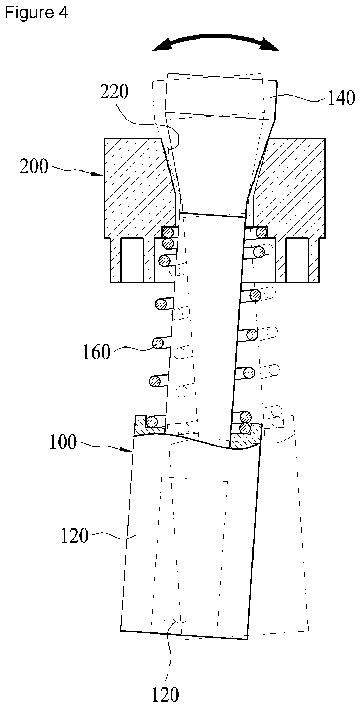

Specifically, as illustrated in FIG. 4, the axis of the probe unit 100 in which the groove 120 is formed is inclined with respect to the axis of the plate unit 200 in a direction to which the external force is applied. At this time, the guide portion 140 is spaced apart from the plate unit 200 at a predetermined interval, and as a result, the guide portion 140 is inclined until the spaced space is filled by the inclined guide portion 140 and may correspond to the external force.

In order to realize the above effects, the guide portion 140 may be formed such that a part thereof becomes larger in width in a longitudinal direction.

The guide portion 140 is formed in a conical shape having a trapezoidal cross section.

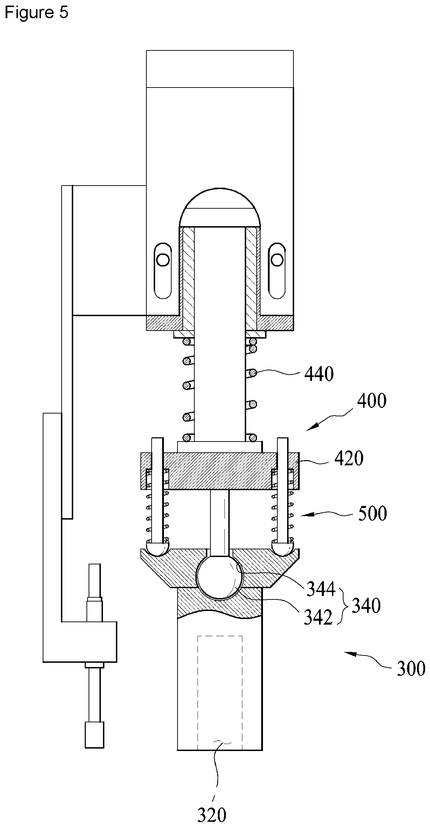

Hereinafter, a second embodiment of a probe device of a floating structure of the present invention will be described with reference to FIGS. 5 to 7. FIGS. 5 to 7 illustrate a second embodiment of a probe device of a floating structure of the present invention.

According to the second embodiment, the probe device of the floating structure of the present invention includes a probe unit 300, a plate unit 400, and an elastic unit 500.

The probe unit 300 has a groove 320 formed at one end thereof into which a needle for transmitting an electrical signal is inserted, and a guide portion 340 formed at the other end thereof.

The needle may serve as a tip input to the terminal, and an area to be contacted or a contacting method may be various. The groove 320 may be formed in response to the area or method in which the needle is contacted, and the needle may be coupled to the groove 320 to transmit an electrical signal.

The guide portion 340 includes a guide member 342 and an accommodation space 344.

One end of the guide member 342 is formed in a spherical shape.

The accommodation space 344 may be formed to accommodate the guide member 342.

The accommodation space 344 is preferably formed in response to the shape of the guide member 342. For example, according to FIGS. 5 to 7, the guide member 342 is formed in a spherical shape, the accommodating space 344 is formed to surround at least a part of the guide member 342, and the guide member 342 may rotate freely in the accommodation space 344.

The plate unit 400 may be installed at one end thereof into which a part of the guide portion 340 is inserted.

That is, a part of the guide portion 340 may be located in the plate unit 400. The plate unit 400 may be a component coupled to a part of a pack terminal block or the pack terminal block and may be formed in various ways.

At this time, the plate unit 400 may include a plate member 420 and a spring member 440.

The plate member 420 may be installed so that the guide portion 340 is inserted.

A part of the guide portion 340 may be fixed to the plate member 420 to face the guide member 342 located in the accommodation space 344. Accordingly, the guide portion 340 may have a constant axis with respect to the plate unit 400 even when an external force is applied.

The spring member 440 may provide a restoring force to the plate member 420 when the external force is removed.

That is, when the needle is removed from the groove 320, the spring member 440 may provide a restoring force to the plate member 420 so that the plate member 420 is restored to a state before the needle is coupled to the groove 320.

The elastic unit 500 may be formed to connect the other end of the probe unit 300 and one end of the plate unit 400, and to be contracted and relaxed according to an external force applied to the needle.

For example, the elastic unit 500 may be provided in plural, and the axis of the probe unit 300 may be inclined with respect to the axis of the guide unit according to the external force.

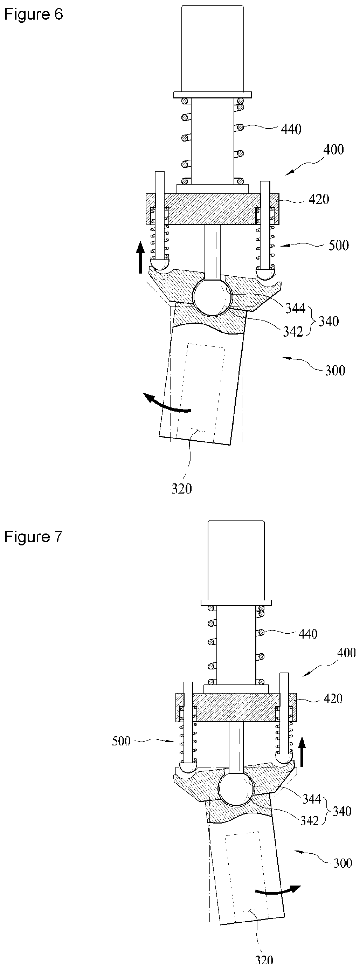

As can be seen in FIGS. 6 and 7, when the needle is coupled to the groove 320, the elastic unit 500 may be contracted and relaxed in a direction of the external force applied to the needle. Therefore, the present invention may compensate for the inclination of the axis of a part of the guide portion 340 generated while the needle is coupled to the groove 320 by interlocking with the elastic unit 500 and the guide member 342.

Specifically, as illustrated in FIG. 6, even when the axis of a part of the guide portion 340 is inclined to the left side with respect to the plate unit 200, the elastic unit 500 at the left side is contracted and the elastic unit 500 at the right side is relaxed and simultaneously, the guide member 342 may rotate freely in the accommodation space 344, thereby compensating for the inclination.

Further, as illustrated in FIG. 7, even when the axis of a part of the guide portion 340 is inclined to the right side with respect to the plate unit 400, the elastic unit 500 at the left side is relaxed and the elastic unit 500 at the right side is contracted and simultaneously, the guide member 342 may rotate freely in the accommodation space 344, thereby compensating for the inclination.
10: Pack terminal block
100: Probe unit
120: Groove
140: Guide portion
160: Elastic portion
200: Plate unit
220: Inner space
300: Probe unit
320: Groove
340: Guide portion
342: Guide member
344: Accommodation space
400: Plate unit
420: Plate member
440: Spring member
500: Elastic unit

## Claims

1. A probe device of a floating structure comprising:
a probe unit (100) having a groove (120) formed at one end thereof into which a needle for transmitting an electrical signal is inserted, and a guide portion (140) formed at the other end thereof; and
a plate unit (200) having an inner space (220) which is inserted with the guide portion (140) and formed to support a part of the guide portion (140),
wherein the guide portion (140) is spaceable apart from the inner space (220) at a predetermined interval by an external force applied to the needle, and
**characterised in that**
the guide portion (140) is formed in a conical shape having a trapezoidal cross-section.

2. The probe device of the floating structure of claim 1, wherein the probe unit (100) includes an elastic portion (160) which is provided to transmit the external force applied to the needle to the guide portion (140).

3. The probe device of the floating structure of claim 1 or 2, wherein the probe unit (100) includes an elastic portion (160) so that the guide portion (140) contacts the inner space (220) when the external force applied to the needle is removed.

4. The probe device of the floating structure of any one of claims 1, 2 or 3, wherein the guide portion (140) is formed such that a part thereof becomes larger in width in a longitudinal direction.

5. A probe device of a floating structure comprising:
a probe unit (300) having a groove (320) formed at one end thereof into which a needle for transmitting an electrical signal is inserted, and a guide portion (340) formed at the other end thereof;
a plate unit (400) installed at one end into which a part of the guide portion (340) is inserted; and
an elastic unit (500) formed to connect the other end of the probe unit (300) and one end of the plate unit (400) and to be contracted and relaxed according to an external force applied to the needle,
and **characterised in that**
the guide portion (340) includes a guide member (342) having one end formed in a spherical shape.

6. The probe device of the floating structure of claim 5, wherein the guide portion (340) includes an accommodation space (344) formed to accommodate the guide member (342).

7. The probe device of the floating structure of any one of claims 5 or 6, wherein the elastic unit (500) is provided in plural.

8. The probe device of the floating structure of any one of claims 5, 6 or 7, wherein an axis of the probe unit (300) is inclined with respect to an axis of the guide portion (340) according to the external force.

9. The probe device of the floating structure of any one of claims 5, 6, 7 or 8, wherein the plate unit (400) includes at least one of:
a plate member (420) installed to be inserted with the guide portion (340); and
a spring member (440) providing a restoring force to the plate member (420) when the external force is removed.

## Patentansprüche

1. Prüfkopf für einen schwebenden Aufbau, der Folgendes umfasst:
eine Prüfeinheit (100), die einen Einschnitt (120), der an einem Ende ausgebildet ist und in den eine Nadel zum Übertragen eines elektrischen Signals eingesetzt ist, und einen Führungsabschnitt (140), der am anderen Ende ausgebildet ist, aufweist; und
eine Platteneinheit (200), die einen Innenraum (220) hat, in den der Führungsabschnitt (140) eingesetzt ist und der so ausgebildet ist, dass er einen Teil des Führungsabschnitts (140) trägt,
wobei der Führungsabschnitt (140) durch eine äußere Kraft, die auf die Nadel ausgeübt wird, vom Innenraum (220) um einen festgelegten Abstand beabstandet werden kann,
**dadurch gekennzeichnet, dass**
der Führungsabschnitt (140) in einer konischen Form ausgebildet ist, die einen trapezförmigen Querschnitt hat.

2. Prüfkopf für den schwebenden Aufbau nach Anspruch 1, wobei die Prüfeinheit (100) einen elastischen Abschnitt (160) umfasst, der vorgesehen ist, um die äußere Kraft, die auf die Nadel ausgeübt wird, an den Führungsabschnitt (140) zu übertragen.

3. Prüfkopf für den schwebenden Aufbau nach Anspruch 1 oder 2, wobei die Prüfeinheit (100) einen elastischen Abschnitt (160) umfasst, so dass der Führungsabschnitt (140) mit dem Innenraum (220) in Kontakt ist, wenn die äußere Kraft, die auf die Nadel ausgeübt wird, entfernt wird.

4. Prüfkopf für einen schwebenden Aufbau nach einem der Ansprüche 1, 2 oder 3, wobei der Führungsabschnitt (140) so ausgebildet ist, dass die Breite eines Teils hiervon in Längsrichtung zunimmt.

5. Prüfkopf für einen schwebenden Aufbau, der Folgendes umfasst:
eine Prüfeinheit (300), die einen Einschnitt (320), der an einem Ende ausgebildet ist und in den eine Nadel zum Übertragen eines elektrischen Signals eingesetzt ist, und einen Führungsabschnitt (340), der am anderen Ende ausgebildet ist, aufweist; und
eine Platteneinheit (400), die an einem Ende installiert ist und in die ein Teil des Führungsabschnitts (340) eingesetzt ist; und
eine elastische Einheit (500), die so ausgebildet ist, dass sie das andere Ende der Prüfeinheit (300) und ein Ende der Platteneinheit (400) verbindet, und die sich entsprechend einer äußeren Kraft, die auf die Nadel ausgeübt wird, zusammenziehen und entspannen kann,
**dadurch gekennzeichnet, dass**
der Führungsabschnitt (340) ein Führungselement (342) aufweist, wovon ein Ende in Kugelform ausgebildet ist.

6. Prüfkopf für den schwebenden Aufbau nach Anspruch 5, wobei der Führungsabschnitt (340) einen Aufnahmeraum (344) aufweist, der ausgebildet ist, um das Führungselement (342) aufzunehmen.

7. Prüfkopf für den schwebenden Aufbau nach einem der Ansprüche 5 oder 6, wobei die elastische Einheit (500) mehrfach vorgesehen ist.

8. Prüfkopf für den schwebenden Aufbau nach einem der Ansprüche 5, 6 oder 7, wobei eine Achse der Prüfeinheit (300) in Bezug auf eine Achse des Führungsabschnitts (340) entsprechend der äußeren Kraft geneigt ist.

9. Prüfkopf für den schwebenden Aufbau nach einem der Ansprüche 5, 6, 7 oder 8, wobei die Platteneinheit (400) wenigstens eines der folgenden Elemente umfasst:
ein Plattenelement (420), das so installiert ist, dass der Führungsabschnitt (340) eingesetzt werden kann; und
ein Federelement (440), das eine Rückstellkraft für das Plattenelement (420) bereitstellt, wenn die äußere Kraft entfernt wird.

## Revendications

1. Dispositif de sonde d'une structure flottante comportant :
une unité de sonde (100) ayant une gorge (120) formée à une extrémité de celle-ci dans laquelle est insérée une aiguille destinée à transmettre un signal électrique, et une portion de guidage (140) formée à l'autre extrémité de celle-ci ; et
une unité de plaque (200) ayant un espace intérieur (220) qui est insérée avec la portion de guidage (140) et formée pour supporter une partie de la portion de guidage (140),
dans lequel la portion de guidage (140) peut être espacée de l'espace intérieur (220) à un intervalle prédéterminé par une force externe appliquée à l'aiguille, et
**caractérisé en ce que**
la portion de guidage (140) est formée avec une forme conique ayant une section transversale trapézoïdale.

2. Dispositif de sonde de la structure flottante selon la revendication 1, dans lequel l'unité de sonde (100) inclut une portion élastique (160) qui est prévue pour transmettre la force externe appliquée à l'aiguille, à la portion de guidage (140).

3. Dispositif de sonde de la structure flottante selon la revendication 1 ou 2, dans lequel l'unité de sonde (100) inclut une portion élastique (160) de sorte que la portion de guidage (140) vient en contact avec l'espace intérieur (220) lorsque la force externe appliquée à l'aiguille est supprimée.

4. Dispositif de sonde de la structure flottante selon l'une quelconque des revendications 1, 2 ou 3, dans lequel la portion de guidage (140) est formée de telle sorte qu'une partie de celle-ci devient plus grande en largeur dans une direction longitudinale.

5. Dispositif de sonde d'une structure flottante comportant :
une unité de sonde (300) ayant une gorge (320) formée à une extrémité de celle-ci dans laquelle est insérée une aiguille destinée à transmettre un signal électrique, et une portion de guidage (340) formée à l'autre extrémité de celle-ci ; et
une unité de plaque (400) installée à une extrémité dans laquelle est insérée une partie de la portion de guidage (340) ; et
une unité élastique (500) formée pour relier l'autre extrémité de l'unité de sonde (300) et une extrémité de l'unité de plaque (400) et pour être comprimée et détendue en fonction d'une force externe appliquée à l'aiguille,
et **caractérisé en ce que**
la portion de guidage (340) inclut un élément de guidage (342) ayant une extrémité formée avec une forme sphérique.

6. Dispositif de sonde de la structure flottante selon la revendication 5, dans lequel la portion de guidage (340) inclut un espace de réception (344) formé pour recevoir l'élément de guidage (342).

7. Dispositif de sonde de la structure flottante selon l'une quelconque des revendications 5 ou 6, dans lequel l'unité élastique (500) est prévue au pluriel.

8. Dispositif de sonde de la structure flottante selon l'une quelconque des revendications 5, 6 ou 7, dans lequel un axe de l'unité de sonde (300) est incliné par rapport à un axe de la portion de guidage (340) en fonction de la force externe.

9. Dispositif de sonde de la structure flottante selon l'une quelconque des revendications 5, 6, 7 ou 8, dans lequel l'unité de plaque (400) inclut au moins un élément parmi :
un élément de plaque (420) installé pour être inséré avec la portion de guidage (340) ; et
un élément à ressort (440) fournissant une force de rappel à l'élément de plaque (420) lorsque la force externe est supprimée.
